# EUROPÄISCHE PATENTSCHRIFT

(11) **EP 2 133 923 B1**
(45) Veröffentlichungstag und Bekanntmachung des Hinweises auf die Patenterteilung: **19.04.2017**
(21) Anmeldenummer: 09007659.7
(22) Anmeldetag: 10.06.2009
(51) Int. Cl.: C22B 9/22, B09B 3/00, B29B 17/02, B29L 9/00, H01L 31/0392, H01L 31/048, C22B 7/00

(54) **Recycling-Verfahren für Dünnschichtsolarzellenmodule**
Recycling method for thin film solar cell modules
Procédé de recyclage pour modules de cellules solaires en couches minces

(30) Priorität: 13.06.2008 DE 102008028425; 15.09.2008 DE 102008047675
(43) Veröffentlichungstag der Anmeldung: 16.12.2009
(73) Patentinhaber: Loser Chemie GmbH, 08134 Langenweißbach (DE)
(72) Erfinder: Wagner, Uwe, 99423 Weimar (DE); Schmieder, Frank, 07616 Bürgel (DE)
(74) Vertreter: Rumrich, Gabriele

(56) Entgegenhaltungen:
- EP-A1- 1 830 411
- EP-B1- 0 893 250
- JP-A- 2004 186 547
- US-A1- 2002 074 318
- US-A1- 2003 116 185

## Beschreibung

Das Verfahren dient dem Recycling von Dünnschichtsolarzellenmodulen mit einer Substratschicht aus Glas oder einem anderen lasertransparenten Material.

Dünnschichtsolarzellenmodule bestehen aus einer Substratschicht, auf die in folgender Reihenfolge eine erste Elektrodenschicht, eine Halbleiterschicht, eine zweite Elektrodenschicht und eine Kunststoffschicht, zum Verkapseln der vorgenannten Funktionsschichten, aufgebracht sind, sowie einer Deckschicht. Die Kunststoffschicht liegt in einem umlaufenden Randbereich unmittelbar an der Substratschicht an.

Das Verfahren ist anwendbar, unabhängig von dem Material der Funktionsschichten, sofern die Substratschicht für die verwendete Laserstrahlung transparent und die erste Elektrodenschicht für die verwendete Laserstrahlung absorbierend ist.

Es ist aus dem Stand der Technik bekannt, eine Strukturierung einzelner oder mehrerer Funktionsschichten sowie eine vollständige Randentschichtung mittels Laserstrahlung durchzuführen, indem eine Laserstrahlung, die von den jeweils abzutragenden Schichten absorbiert wird, relativ zur freien Oberfläche der lasertransparenten Substratschicht und auf diese gerichtet geführt wird.

In der US 2002 0074318 A1 wird ein solches Verfahren näher beschrieben, welches zur Randentschichtung von Solarzellen vor deren Verkapselung verwendet wird. Dabei weisen die Solarzellen die oben angeführten Schichten auf. Als Deckschicht dient eine Platte aus Fensterglas.

Ein auf einem in einer x-y Ebene beweglichen Tisch befestigtes Werkstück wird über die Ausdehnung der zu trennenden Schichten an einem für die vorgesehene Bearbeitung ausgeformten Laserstrahl vorbeigeführt und durch diesen beaufschlagt. Dabei kann der Laserstrahl die jeweils zu bearbeitende und absorbierende Schicht des Werkstückes sowohl direkt als auch durch eine lasertransparente Substratschicht hindurch erreichen. Die bei der Bearbeitung freigesetzten Gase und Dämpfe entweichen und werden bei Bedarf durch Abzugseinrichtungen weggeführt. In der Patentschrift EP 0 893 250 B1 ist ein Verfahren zum Trennen der Komponenten einer Verbundglasscheibe offenbart. Anhand von als photovoltaische Solarmodule ausgebildeten Verbundglasscheiben wird die Trennung der Abdeck-und Trägerscheibe von den die Scheiben verbindenden und aus Kunststoff bestehenden Verbundschichten beschrieben. Unter Einhaltung bestimmter Aufheizraten werden die Verbundglasscheiben in einem Ofen auf bestimmte Endtemperaturen geheizt. Unter Einwirkung der Temperatur, äußerer Kräfte und gegebenenfalls mit Unterstützung von Oxidationsmitteln werden die Scheiben vollständig von der Verbundschicht befreit. Nachteilig ist jedoch, dass sich bei Dünnschicht-Solarmodulen die photovoltaisch wirksame Schicht nicht ohne Oxidation dieser Schicht und damit unter Entstehung von möglicherweise giftigen Abgasen entfernen lässt.

Erfindungsgemäß für die vorliegende Erfindung ist ein Verfahren zum Recycling von Dünnschichtsolarzellenmodulen, wobei bei dem Verfahren die Dünnschichtsolarzellenmodule aus einer Substratschicht mit einem Schichtaufbau von Funktionsschichten, bestehend aus einer ersten Elektrodenschicht, einer Halbleiterschicht und einer zweiten Elektrodenschicht sowie einer Kunststoffschicht zum Verkapseln der vorgenannten Funktionsschichten, die in einem umlaufenden Randbereich, einen Innenbereich einschließend, unmittelbar an der Substratschicht anliegt, und einer Deckschicht bestehen und wobei die Substratschicht für eine Bearbeitungslaserstrahlung transparent und die erste Elektrodenschicht für diese Bearbeitungslaserstrahlung absorbierend ist, wobei erfindungsgemäß die freie Oberfläche der Substratschicht vollständig über den Innenbereich mit der Bearbeitungslaserstrahlung abgescannt wird, wodurch die erste Elektrodenschicht durch die Absorption der Bearbeitungslaserstrahlung wenigstens teilweise verdampft, wobei sich der Schichtaufbau der Funktionsschichten von der Substratschicht löst und ein Gasvolumen entsteht, womit verhindert wird, dass sich der Schichtaufbau der Funktionsschichten wieder mit der Substratschicht verbindet, sodass die Substratschicht, getrennt von den mit der Kunststoffschicht und der Deckschicht verbundenen Funktionsschichten, zur weiteren getrennten Verarbeitung zur Verfügung steht.

Das erfindungsgemäße Verfahren verwendet zwingend eine Laserstrahlung, für die die erste Elektrodenschicht absorbierend ist. Das heißt, Hersteller von Solarzellenmodulen, die eine Randentschichtung und/oder eine Strukturierung wenigstens der ersten Elektrodenschicht mit einem Laser vornehmen, können mit diesem Laser auch das Recycling-Verfahren durchführen.

Auch Vorrichtungen, die eine für die Randentschichtung geeignete Strahlaufweitung und Strahlformung bewirken, sind für das erfindungsgemäße Verfahren geeignet.

Im Unterschied zur Strukturierung und der Randentschichtung, wo es darauf ankommt, die Schichten entlang der Spuren über eine Breite im Bereich von 20 µm bis 90 µm bzw. von 10 mm bis 60 mm vollständig abzutragen, ohne dabei den Substratträger zu beschädigen, ist eine mögliche Beschädigung des Substratträgers beim Recycling-Verfahren ohne Bedeutung.

Es geht vergleichsweise auch nicht um den vollständigen Abtrag einer oder mehrerer Schichten, sondern nur um ein Lösen des Schichtaufbaus der Funktionsschichten von der Substratschicht, wobei nur die erste Elektrodenschicht wenigstens teilweise verdampft wird und die nachfolgende Halbleiterschicht möglichst unbeeinflusst bleibt.

Gleichzeitig muss die lokale thermische Belastung durch den Energieeintrag so gering gehalten werden, dass die Kunststoffschicht nicht zum Schmelzen kommt, damit die Kunststoffschicht und die erhalten bleibenden Funktionsschichten möglichst in einem Stück an der Deckschicht haften bleiben.

Die Erfindung soll nachfolgend anhand von Ausführungsbeispielen näher erläutert werden.

Zur Durchführung des Verfahrens wird für alle Ausführungsbeispiele gleich die Sübstratschicht des Dünnschichtsolarzellenmoduls von ihrer freien Oberfläche her mit der Bearbeitungslaserstrahlung abgescannt.

Gemäß einem ersten Ausführungsbeispiel wird dabei zuerst der vom Randbereich eingeschlossene Innenbereich vollständig abgescannt, damit die sich bei der Materialverdampfung bildenden Gase nicht entweichen können. Mit dem entstehenden eingeschlossenen Gasvolumen wird insbesondere verhindert, dass entstehende Schmelze des Materials der ersten Elektrodenschicht an der Substratschicht erstarrt und sich so der Schichtverbund der Funktionsschichten teilweise wieder mit der Substratschicht verbinden kann.

Das Abscannen erfolgt vorteilhaft in Spuren, die in Längs- oder Querrichtung des üblicherweise rechteckförmigen Dünnschichtsolarzellenmoduls verlaufen. Indem die Spuren unmittelbar aneinander angrenzend abgescannt werden, entsteht eine geschlossene Fläche, über die sich die erste Elektrodenschicht von der Substratschicht löst und es kann sich ein Gasvolumen in dem entstehenden Zwischenraum ausbilden.

Dieses Scanregime führt allerdings zu einer hohen thermischen Belastung, die insbesondere die Kunststoffschicht unerwünscht erweicht.

Die thermische Belastung wird verringert, wenn die Spuren in einem Abstand zueinander abgescannt werden, der gleich der Spurbreite oder einem Vielfachen der Spurbreite ist.

Indem die Oberfläche in zueinander beabstandeten Spuren mit der Bearbeitungslaserstrahlung beaufschlagt wird und anschließend hierzu mit einem gleichen Spurabstand versetzte Spuren in den Abstandsbereichen beaufschlagt werden, erfolgt ein örtlich und zeitlich gleichmäßigerer Energieeintrag, als wenn nacheinander aneinander grenzende Spuren abgescannt werden.

Die thermische Belastung auf die Kunststoffschicht wird damit bei ansonsten gleichen Verfahrensparametern, die auf eine geringe Prozesszeit ausgerichtet sind, verringert.

Das Abscannen einer Spur erfolgt vorteilhaft, indem die Bearbeitungslaserstrahlung in eine Linie quer zur Spurrichtung fokussiert und in Spurrichtung geführt wird.Oder ein Scanner wird in Spurrichtung relativ zum Dünnschichtsolarzellenmodul bewegt, während der Laserstrahl die Spur in Richtung der Spurbreite abscannt.

Durch die Überlagerung der beiden Bewegungen wird die gesamte Oberfläche innerhalb der Spur mit Laserstrahlung nacheinander beaufschlagt, wobei die Spurbreite über die Vorgabe des Scanwinkels variierbar ist.

Vorteilhaft kann die Kunststoffschicht während des Scanprozesses seitens der Deckschicht gekühlt werden, indem z. B. das Dünnschichtsolarzellenmodul mit der Deckschicht auf eine Wärmesenke ganzflächig aufgelegt wird.

Nachdem der Innenbereich vollständig abgescannt wurde und sich folglich der Schichtverbund der Funktionsschichten von der Substratschicht gelöst hat, haftet nur noch die Kunststoffschicht im Randbereich an der Substratschicht.

Diese Verbindung könnte nun ebenfalls mittels Laserstrahlung gelöst werden.

Vorteilhaft wird die Kunststoffschicht jedoch nur über Wärmestrahlung oder Wärmeleitung von der Substratschicht her im Randbereich gleichmäßig bis zur Erweichungstemperatur erwärmt, um diese dann, noch immer an der Deckschicht haftend, mit der Deckschicht und den daran noch haftenden Funktionsschichten von der Substratplatte abziehen zu können. Dabei bleibt die Kunststoffschicht, die jetzt nur im Randbereich erwärmt wurde, im Innenbereich mit der Deckschicht verbunden.

Nach diesem Verfahrensschritt ist die Substratschicht vom Rest des Dünnschichtsolarzellenmoduls getrennt.

Auf gleiche Weise, wie die Kunststoffschicht im Randbereich von der Substratschicht gelöst wurde, kann anschließend die Kunststoffschicht mit dem noch verbliebenen Schichtaufbau der Funktionsschichten von der Deckschicht getrennt werden.

Abschließend stehen einerseits die Substratschicht und die Deckschicht, die häufig aus dem gleichen Material, insbesondere Glas bestehen, und andererseits die Kunststoffschicht, verbunden mit der zweiten Elektrodenschicht und der Halbleiterschicht, zur weiteren getrennten Verarbeitung zur Verfügung.

Wie praktische Versuche gezeigt haben, ist es nicht in jedem Fall von Vorteil, wenn das entstehende Gasvolumen eingeschlossen bleibt.

Das heißt, ob es für den Prozess von Vorteil ist, das entstehende Gasvolumen zwischen der Substratschicht und der ersten Elektrodenschicht zu halten bzw. dieses durch eine zusätzliche Gaszuführung zu vergrößern oder durch eine Gasabführung zu verringern, wird insbesondere durch die Eigenschaften des Materials der ersten Elektrodenschicht bestimmt.

In einem zweiten Ausführungsbeispiel soll daher über den Randbereich, in dem die Kunststoffschicht unmittelbar auf der Substratschicht haftet, wenigstens eine Öffnung geschaffen werden, bevor entsprechend dem ersten Ausführungsbeispiel der Innenbereich abgescannt wird.

Die Öffnung kann durch eine lokale Erwärmung im Randbereich, z. B. mit Heißluft gebildet werden und durch das Einschieben von Keilen oder Rohrstücken offen gehalten werden. Über die Öffnung kann nun das entstehende Gasvolumen ganz oder teilweise entweichen. Ebenso kann über diese Öffnung ein Fremdgas zugeführt werden, um einen leichten Überdruck zu erzeugen, der den Ablöseprozess unterstützt.

## Patentansprüche

1. Verfahren zum Recycling von Dünnschichtsolarzellenmodulen, wobei bei dem Verfahren die Dünnschichtsolarzellenmodule aus einer Substratschicht mit einem Schichtaufbau von Funktionsschichten, bestehend aus einer ersten Elektrodenschicht, einer Halbleiterschicht und einer zweiten Elektrodenschicht sowie einer Kunststoffschicht zum Verkapseln der vorgenannten Funktionsschichten, die in einem umlaufenden Randbereich, einen Innenbereich einschließend, unmittelbar an der Substratschicht anliegt, und einer Deckschicht bestehen und wobei die Substratschicht für eine Bearbeitungslaserstrahlung transparent und die erste Elektrodenschicht für diese Bearbeitungslaserstrahlung absorbierend ist, **dadurch gekennzeichnet, dass** die freie Oberfläche der Substratschicht vollständig über den Innenbereich mit der Bearbeitungslaserstrahlung abgescannt wird, wodurch die erste Elektrodenschicht durch die Absorption der Bearbeitungslaserstrahlung wenigstens teilweise verdampft, wobei sich der Schichtaufbau der Funktionsschichten von der Substratschicht löst und ein Gasvolumen entsteht, womit verhindert wird, dass sich der Schichtaufbau der Funktionsschichten wieder mit der Substratschicht verbindet, sodass die Substratschicht, getrennt von den mit der Kunststoffschicht und der Deckschicht verbundenen Funktionsschichten, zur weiteren getrennten Verarbeitung zur Verfügung steht.

2. Verfahren zum Recycling von Dünnschichtsolarzellenmodulen nach Anspruch 1, **dadurch gekennzeichnet, dass** die Kunststoffschicht über die Deckschicht bis zu ihrer Erweichungstemperatur erwärmt wird und die Deckschicht von der Kunststoffschicht abgezogen wird, sodass die Deckschicht, getrennt von den mit der Kunststoffschicht verbundenen Funktionsschichten, zur weiteren getrennten Verarbeitung zur Verfügung steht.

3. Verfahren zum Recycling von Dünnschichtsolarzellenmodulen nach Anspruch 1, **dadurch gekennzeichnet, dass** der Randbereich anschließend erwärmt wird.

4. Verfahren zum Recycling von Dünnschichtsolarzellenmodulen nach Anspruch 3, **dadurch gekennzeichnet, dass** der Innenbereich entlang aneinander grenzender Spuren abgescannt wird, wodurch eine geschlossene Fläche entsteht, über die sich die erste Elektrodenschicht von der Substratschicht löst.

5. Verfahren zum Recycling von Dünnschichtsolarzellenmodulen nach Anspruch 1, **dadurch gekennzeichnet, dass** der Innenbereich entlang voneinander beabstandeten Spuren abgescannt wird, mit einem Abstand gleich der Spurbreite oder einem Vielfachen der Spurbreite, wodurch die thermische Belastung reduziert wird.

6. Verfahren zum Recycling von Dünnschichtsolarzellenmodulen nach Anspruch 1, **dadurch gekennzeichnet, dass** die Kunststoffschicht während des Scanprozesses seitens der Deckschicht gekühlt wird.

7. Verfahren zum Recycling von Dünnschichtsolarzellenmodulen nach Anspruch 1, **dadurch gekennzeichnet, dass** im umlaufenden Randbereich wenigstens eine Öffnung geschaffen wird, bevor der Innenbereich abgescannt wird.

8. Verfahren zum Recycling von Dünnschichtsolarzellenmodulen nach Anspruch 7, **dadurch gekennzeichnet, dass** durch die wenigstens eine geschaffene Öffnung das entstehende Gasvolumen entweicht.

9. Verfahren zum Recycling von Dünnschichtsolarzellenmodulen nach Anspruch 7, **dadurch gekennzeichnet, dass** durch die wenigstens eine geschaffene Öffnung Fremdgase zugeführt werden.

## Claims

1. A method for recycling thin-film solar cell modules, wherein the thin-film solar cell modules consist in the method of a substrate layer with a layer structure of functional layers, consisting of a first electrode layer, a semiconductor layer and a second electrode layer, as well as a plastic layer for encapsulating the aforementioned functional layers, which rests in a circumferential boundary region directly on the substrate layer, thereby enclosing an interior region, and of a cover layer, and wherein the substrate layer is transparent for working laser radiation and the first electrode layer is absorbent for said working laser radiation, **characterized in that** the free surface of the substrate layer is scanned completely over the inner region with the working laser radiation, as a result of which the first electrode layer evaporates at least partly by a absorption of the working laser radiation, wherein the layer structure of the functional layers detaches from the substrate layer and a gas volume is produced, thus preventing that the layer structure of the functional layers connects again to the substrate layer, so that the substrate layer, separated from the functional layers connected to the plastic layer and the cover layer, is available for further separate processing.

2. A method for recycling thin-film solar cell modules according to claim 1, **characterized in that** the plastic layer is heated via the cover layer up to its softening temperature and the cover layer is drawn off from the plastic layer, so that the cover layer, separated from the functional layers connected to the plastic layer, is available for further separate processing.

3. A method for recycling thin-film solar cell modules according to claim 1, **characterized in that** the boundary region is subsequently heated.

4. A method for recycling thin-film solar cell modules according to claim 3, **characterized in that** the inner region is scanned along mutually adjoining tracks, thus producing a closed surface via which the first electrode layer detaches from the substrate layer.

5. A method for recycling thin-film solar cell modules according to claim 1, **characterized in that** the inner region is scanned along mutually spaced tracks, at a distance equal to the track width or a multiple of the track width, thus reducing the thermal loading.

6. A method for recycling thin-film solar cell modules according to claim 1, **characterized in that** the plastic layer is cooled during the scanning process by the cover layer.

7. A method for recycling thin-film solar cell modules according to claim 1, **characterized in that** in the circumferential boundary region at least one opening is produced before the inner region is scanned.

8. A method for recycling thin-film solar cell modules according to claim 7, **characterized in that** the produced gas volume escapes through the at least one produced opening.

9. A method for recycling thin-film solar cell modules according to claim 7, **characterized in that** foreign gases are supplied through the at least one produced opening.

## Revendications

1. Procédé pour le recyclage de modules de cellules solaires à couches minces, dans lequel les modules de cellules solaires à couches minces se composent d'une couche de substrat avec une structure de couches fonctionnelles composées d'une première couche d'électrodes, d'une couche de semi-conducteurs et d'une deuxième couche d'électrodes ainsi que d'une couche de plastique pour encapsuler lesdites couches fonctionnelles, qui repose directement sur la couche de substrat dans une zone de bord périphérique renfermant une zone intérieure, et d'une couche de couverture, et dans lequel la couche de substrat est transparente à un rayonnement laser de travail et la première couche d'électrodes absorbe ce rayonnement laser de travail, **caractérisé en ce que** la surface libre de la couche de substrat est entièrement balayée sur la zone intérieure avec le rayonnement laser de travail, de sorte que la première couche d'électrodes est au moins partiellement vaporisée par l'absorption du rayonnement laser de travail, la structure des couches fonctionnelles se détachant alors de la couche de substrat et un volume de gaz se créant et empêchant que la structure des couches fonctionnelles se lie à nouveau à la couche de substrat, de sorte que la couche de substrat, séparée des couches fonctionnelles reliées à la couche de plastique et à la couche de couverture, est mise à disposition pour la suite d'une transformation séparée.

2. Procédé pour le recyclage de modules de cellules solaires à couches minces selon la revendication 1, **caractérisé en ce que** la couche de plastique est chauffée par l'intermédiaire de la couche de couverture jusqu'à sa température de ramollissement et la couche de couverture est retirée de la couche de plastique, de sorte que la couche de couverture, séparée des couches fonctionnelles reliées à la couche de plastique, est mise à disposition pour pour la suite d'une transformation séparée.

3. Procédé pour le recyclage de modules de cellules solaires à couches minces selon la revendication 1, **caractérisé en ce que** la zone de bord est ensuite chauffée.

4. Procédé pour le recyclage de modules de cellules solaires à couches minces selon la revendication 3, **caractérisé en ce que** la zone intérieure est balayée le long de trajets contigus, ce qui crée une surface continue par-dessus laquelle la première couche d'électrodes se détache de la couche de substrat.

5. Procédé pour le recyclage de modules de cellules solaires à couches minces selon la revendication 1, **caractérisé en ce que** la zone intérieure est balayée le long de trajets écartés les unes des autres, avec un écartement égal à la largeur des trajets ou à un multiple de la largeur des trajets, ce qui réduit les contraintes thermiques.

6. Procédé pour le recyclage de modules de cellules solaires à couches minces selon la revendication 1, **caractérisé en ce que** la couche de plastique est refroidie pendant le processus de balayage du côté de la couche de couverture.

7. Procédé pour le recyclage de modules de cellules solaires à couches minces selon la revendication 1, **caractérisé en ce qu'**au moins une ouverture est créée dans la zone de bord périphérique avant le balayage de la zone intérieure.

8. Procédé pour le recyclage de modules de cellules solaires à couches minces selon la revendication 7, **caractérisé en ce que** le volume de gaz produit s'échappe à travers l'au mois une ouverture créée.

9. Procédé pour le recyclage de modules de cellules solaires à couches minces selon la revendication 7, **caractérisé en ce que** des gaz de l'extérieur sont amenés à travers l'au moins une ouverture créée.
